# FASCICULE DE BREVET EUROPEEN

(11) **EP 2 940 690 B1**
(45) Date de publication et mention de la délivrance du brevet: **05.07.2017**
(21) Numéro de dépôt: 15156430.9
(22) Date de dépôt: 24.02.2015
(51) Int. Cl.: G11C 16/10, H03K 21/40, G06F 12/02, G06F 9/30, H03K 23/56

(54) **Compteur bidirectionnel en mémoire flash**
Bidirektionaler Zähler in einem Flash-Speicher
Bi-directional counter in flash memory

(30) Priorité: 30.04.2014 FR 1453938
(43) Date de publication de la demande: 04.11.2015
(73) Titulaire: Proton World International N.V., 1831 Diegem (BE)
(72) Inventeur: van Keer, Ronny, 1560 Hoeilaart (BE); Docquier, Guillaume, 4000 Liège (BE)
(74) Mandataire: Thibon, Laurent

(56) Documents cités:
- US-A1- 2007 189 082
- US-A1- 2009 313 418

## Description

### Domaine

La présente description concerne de façon générale les circuits électroniques et, plus particulièrement, les circuits exploitant une mémoire flash. La présente description vise plus particulièrement la réalisation d'un compteur dont la valeur est stockée dans une mémoire flash ou dans une mémoire de type EEPROM.

### Exposé de l'art antérieur

Dans de nombreuses applications, on a besoin de stocker de façon non volatile le résultat d'un compteur afin qu'il soit conservé indépendamment de l'alimentation du circuit. C'est le cas notamment dans les cartes à microcircuits qui intègrent un microprocesseur et au moins une mémoire non volatile, et plus généralement dans tout circuit électronique requérant des éléments de comptage en mémoire non volatile.

Le document US-A-2009/0313418 décrit l'utilisation d'une mémoire asymétrique ainsi qu'un procédé de stockage d'un compteur dans au moins deux pages de mémoire non volatile comportant :une étape d'initialisation des au moins deux pages avec une valeur d'effacement, suivie d'une étape de stockage dans une portion d'une des deux pages d'une valeur initiale du compteur; puis-à chaque mise à jour de la valeur du compteur, une étape de stockage dans ladite une des deux pages d'un opérande associé à un code opératoire choisi parmi un ensemble de codes opératoires, la valeur courante du compteur étant donnée par application d'opérations de mise à jour successives à la valeur initiale du compteur stockée dans ladite une des deux pages, ces opérations étant désignées par les codes opératoires et les opérandes associés stockés dans ladite une des deux pages. Ce procédé ne comprend pas l'étape de, à chaque mise à jour de la valeur du compteur, stockage dans ladite une des deux pages du code opératoire. Le document US-A-2007/0189082 décrit un procédé de réalisation d'un compteur dans une mémoire.

### Résumé

Suite au développement des mémoires de type flash, il serait souhaitable de pouvoir utiliser ces mémoires pour stocker les valeurs de compteurs.

Par ailleurs, il serait souhaitable de disposer d'un compteur en mémoire non volatile (flash ou EEPROM) qui puisse être incrémenté et décrémenté.

Ainsi, un mode de réalisation prévoit un procédé de stockage d'un compteur dans au moins deux pages de mémoire non volatile, comportant :
une étape d'initialisation des au moins deux pages avec une valeur d'effacement initiale,
une étape de stockage dans une portion d'une des deux pages d'une valeur initiale du compteur ; puis
à chaque mise à jour de la valeur du compteur, une étape de stockage, dans ladite une des deux pages, d'un code opératoire et d'un opérande associé à ce code opératoire, choisi parmi un ensemble de codes opératoires,
la valeur courante du compteur étant donnée par application d'opérations de mise à jour successives à la valeur initiale du compteur stocké dans ladite page, ces opérations étant désignées par les codes opératoires et les opérandes associés stockés dans ladite page.

Selon un mode de réalisation, quand une page est pleine, sa valeur finale est calculée, puis stockée comme valeur initiale de la page suivante.

Selon un mode de réalisation, le procédé comporte une étape initiale dans laquelle toutes les pages mémoire destinées au compteur sont initialisées dans un premier état.

Selon un mode de réalisation, les codes opératoires comportent au moins un code parmi l'addition et la soustraction.

Selon un mode de réalisation, les codes opératoires comportent un code d'effacement d'une page entière de la mémoire.

Selon un mode de réalisation, les codes opératoires comportent un code d'effacement de l'opération précédente.

Selon un mode de réalisation, une page comporte 32, 64, 128, 256, 512, 1024 ou 2048 octets.

Un mode de réalisation prévoit une mémoire flash, programmée conformément au procédé ci-dessus.

Un mode de réalisation prévoit un circuit électronique comportant une telle mémoire flash.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est un schéma-bloc d'un exemple de circuit électronique du type auquel s'appliquent les modes de réalisation qui vont être décrits ;
la figure 2 illustre, de façon très schématique et sous forme de blocs, un exemple de système exploitant un routeur NFC ;
la figure 3 est une représentation schématique d'un exemple de mémoire flash ; et
la figure 4 illustre un mode de mise en oeuvre du procédé de programmation d'un compteur dans une mémoire flash.

### Description détaillée

De mêmes éléments ont été désignés par de mêmes références aux différentes figures. Par souci de clarté, seuls les étapes et éléments utiles à la compréhension des modes de réalisation qui vont être décrits ont été représentés et seront détaillés. En particulier, le fonctionnement électrique d'une mémoire flash ou EEPROM lors des étapes d'écriture, de lecture et d'effacement n'a pas été détaillé, les modes de réalisation décrits étant compatibles avec les technologies usuelles des mémoires flash et EEPROM. De plus, les applications utilisant la mise à jour d'un compteur à stocker dans une mémoire flash ou EEPROM n'ont pas non plus été détaillées, les modes de réalisation décrits étant, là encore, compatibles avec les applications usuelles.

Utiliser une mémoire non volatile pour stocker un compteur pose problème quand on souhaite minimiser le nombre d'étapes d'effacement.

Traditionnellement, lorsqu'un compteur est stocké dans une mémoire EEPROM, la programmation et l'effacement s'effectuent par octet ou par mot dans la mémoire, ce qui offre une granularité suffisante.

D'une part, il serait souhaitable de minimiser le nombre d'effacements pour accroître la durée de vie de la mémoire.

D'autre part, un tel fonctionnement est incompatible avec une mémoire flash.

Une mémoire flash se programme, à partir d'un état initial vers des états 0 (états non conducteurs des cellules). Cela signifie que les cellules de la mémoire doivent être initialisées à un état haut et que, pour stocker une donnée, on choisit soit de ne pas intervenir sur l'état du bit, soit de programmer ce bit à 0.

Une mémoire EEPROM se programme de façon similaire mais à partir d'un état initial vers des états 1.

On notera que la référence à un état 1 ou à un état 0 est une pure convention pour désigner des points mémoires respectivement chargés ou déchargés.

Par ailleurs, un effacement (remise dans l'état initial) s'effectue forcément par page mémoire. Une page est définie comme la taille minimale susceptible d'être adressée simultanément pour effacement. En pratique, cela correspond à la taille d'un registre recevant les données en série pour les transférer en parallèle au plan mémoire pour stockage. Typiquement, une page représente actuellement, dans une mémoire flash, 32, 64, 128, 256, 512, 1024 ou 2048 octets.

Or, un compteur requiert de changer l'état d'un seul bit (ou de quelques bits selon le pas d'incrément/décrément).

Que ce soit dans une mémoire flash ou dans une mémoire EEPROM, l'opération d'effacement d'une page est relativement longue (typiquement de l'ordre de quelques millisecondes) par rapport à une opération de programmation d'un octet (typiquement de l'ordre de la dizaine de microsecondes).

Un processus consistant à effacer la page pour programmer le nouvel état du compteur à chaque incrément prendrait trop de temps. En particulier, dans de nombreuses applications, le temps disponible pour écrire en mémoire non volatile est limité. C'est en particulier le cas dans des applications exploitant une technologie de communication en champ proche et sans contact (NFC - Near Field Communication) car la durée de la transaction entre deux éléments communiquant n'est que temporaire et risque à tout moment d'être interrompue. Or, l'utilisation d'un compteur en mémoire non volatile est, dans ces applications, souvent liée à des questions de sécurité en termes d'accès à certaines informations. La fiabilité du compteur est alors critique. On peut être amené à mettre en oeuvre des procédures dites d'atomicité pour améliorer cette fiabilité. Toutefois, ces procédures accroissent encore le besoin de mise à jour d'informations en mémoire non volatile.

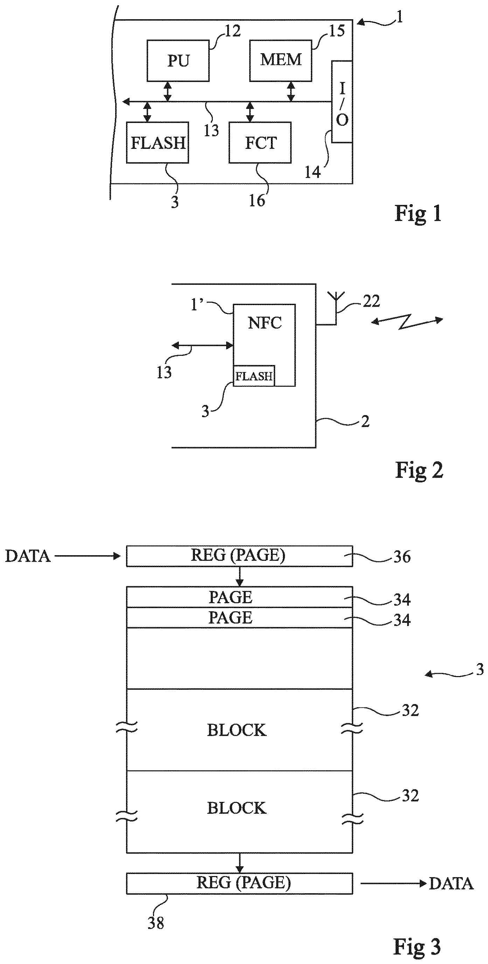

La figure 1 représente, schématiquement, sous forme de blocs, un exemple de circuit électronique 1 du type auquel s'appliquent les modes de réalisation qui vont être décrits. Un tel circuit comporte une unité de traitement 12 (PU) susceptible de communiquer, par l'intermédiaire d'un ou plusieurs bus 13 de données, d'adresses et de commandes, avec différents éléments parmi lesquels, par exemple, une interface d'entrée/sortie 14 (I/O) de communication avec l'extérieur du circuit 1, une ou plusieurs mémoires 15 (MEM) volatiles ou non volatiles, une ou plusieurs fonctions (symbolisées par un bloc 16, FCT) liées à l'application, et au moins une mémoire flash 3 (FLASH) ou EEPROM dans laquelle on souhaite stocker un compteur. D'autres éléments sont susceptibles d'être raccordés aux bus 13 et/ou d'être inclus dans le circuit. Le cas échéant, la mémoire 3 est externe au circuit 1.

On prendra par la suite l'exemple d'une mémoire flash pour stocker le compteur. Toutefois, les techniques qui vont être décrites s'appliquent également à la gestion d'un compteur stocké en mémoire EEPROM, bien que les opérations d'écriture et d'effacement n'aient pas obligatoirement la même granularité.

La figure 2 est une représentation schématique d'un exemple de dispositif 2 incluant un ou plusieurs circuits électroniques 1' formant un routeur de communication en champ proche (NFC) susceptible de communiquer par différents bus 13 avec le reste du dispositif 2. Le routeur NFC sert d'interface entre les différents éléments du dispositif 2 et une antenne 22 de communication en champ proche avec un dispositif voisin non représenté. Dans l'exemple de la figure 2, le circuit NFC inclut au moins une mémoire flash 3.

Les applications visées par la présente description exploitent au moins un compteur dont la valeur est stockée dans cette mémoire flash.

La figure 3 illustre, de façon très schématique un exemple d'architecture d'une mémoire flash 3, une telle mémoire est généralement organisée en blocs 32 (BLOCK) comportant chacun plusieurs pages 34 (PAGE), chacune d'un nombre donné d'octets, par exemple de 512, 1024 ou 2048 octets. L'écriture de données DATA dans la mémoire 3 ou l'effacement s'effectue par l'intermédiaire d'un registre d'entrée 36 (REG). Les données sont typiquement envoyées dans une communication série, ou par octet, dans le registre 36 d'écriture qui est ensuite déchargé en parallèle vers un bloc de la mémoire. En lecture, l'adressage d'une zone conduit également à la lecture d'une page à travers un registre de sortie 38 qui fournit les données lues à l'extérieur.

La représentation de la figure 3 est schématique et les différents circuits de commande et d'adressage n'ont pas été illustrés.

L'utilisation normale d'une mémoire flash pour stocker des données de taille inférieure à la page prendrait trop de temps. En effet, à chaque nouvelle valeur devant être stockée dans le compteur, il serait nécessaire d'effacer toute la page pour pouvoir reprogrammer une nouvelle valeur.

Dans les modes de réalisation qui vont être décrits, on prévoit d'affecter plusieurs pages (au moins deux) au compteur et d'initialiser ces pages en les effaçant (en les remplissant d'états 1, ou FF en notation hexadécimale). Puis, au lieu de stocker la valeur du compteur dans la mémoire, on prévoit de stocker une valeur initiale du compteur suivie d'une série de valeurs d'incrément ou de décrément et les opérations qui leur sont associées.

Ainsi, le circuit de contrôle du compteur (l'unité de traitement 12) gère au moins un et de préférence quatre codes opératoires permettant le fonctionnement du compteur en mémoire non volatile. Ces quatre codes opératoires sont :
- Absence d'opération (optionnel) : cette opération revient à annuler l'opération juste précédente ;
- Addition : cette opération consiste à incrémenter la valeur du compteur de l'opérande associé au code opératoire ;
- Soustraction : cette opération consiste à décrémenter la valeur du compteur de l'opérande associé au code opératoire ; et
- Effacement (optionnel) : cette opération revient à effacer une page entière (la mettre à 1 (FF) entièrement).

Lors de l'écriture du compteur, c'est-à-dire d'un incrément ou décrément, l'unité de traitement gérant le compteur écrit, dans la mémoire, un code opératoire et un opérande associé à ce code.

Lors de la lecture de la valeur du compteur, l'unité de traitement lit la valeur initiale de la page stockée dans le premier mot de cette page, ainsi que les différentes opérations (codes opératoires et opérandes) stockées dans la page active.

Lorsqu'une page est pleine, la page suivante est initialisée en stockant comme valeur initiale le résultat de la page précédente (valeur initiale mise à jour par toutes les opérations de la page). Ainsi, l'unité de traitement n'a pas besoin de recalculer à chaque lecture l'ensemble des pages pour obtenir la valeur courante du compteur, mais seulement la page courante.

On tire ainsi profit d'une écriture par octets qui est rapide et on réserve les étapes d'effacement relativement longues (par rapport à une opération d'écriture) lorsque toute la page est pleine.

On tire également profit du fait qu'une mémoire flash se lit de toute façon par page entière. Par conséquent, il n'est pas préjudiciable de devoir lire toute une page pour calculer la valeur courante du compteur.

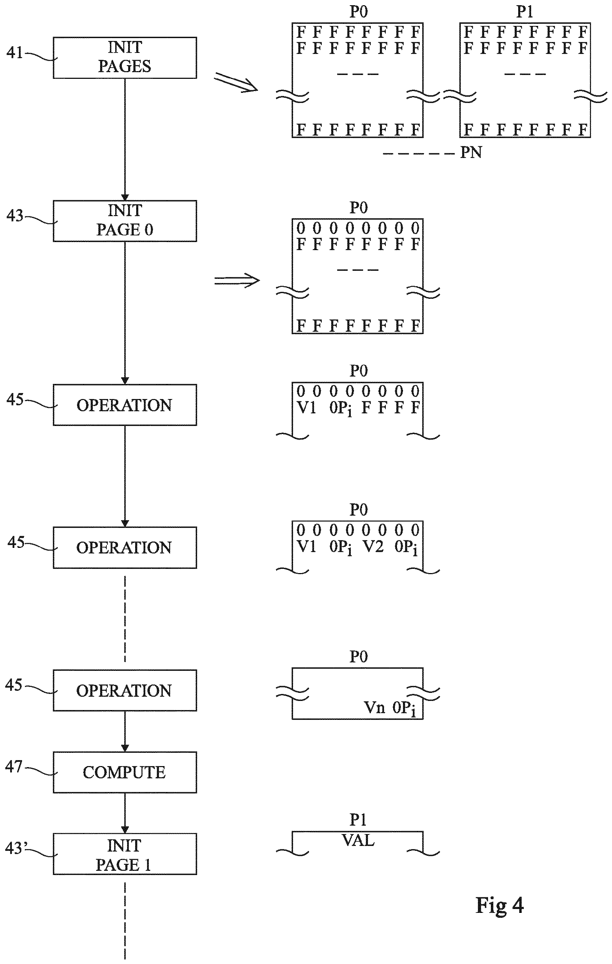

La figure 4 illustre, de façon très schématique, un mode de mise en oeuvre d'un procédé de mise à jour d'un compteur dans une mémoire flash.

Dans une phase d'initialisation du compteur, on commence par initialiser (bloc 41, INIT PAGES) toutes les pages affectées au compteur. Cette initialisation correspond à remplir tous les bits à l'état 1. En figure 4, le contenu des octets a été noté en hexadécimal. Ainsi, dans l'exemple de la figure 4, chaque ligne comporte 8 octets.

De préférence, on affecte quatre octets à chaque opération de mise à jour du compteur (code opératoire et opérande).

Une fois les pages initialisées, on provoque l'initialisation de la première page (bloc 43, INIT PAGE 0) par stockage de cette valeur initiale dans sa première adresse. Par exemple, cette initialisation est à la valeur nulle 00 et les quatre premiers octets de la page sont écrits à 0.

Le compteur est alors prêt à être utilisé.

Lors d'une première opération de mise à jour de la valeur du compteur, l'unité de traitement envoie une opération (bloc 45, OPERATION) représentant l'incrément ou le décrément à affecter au compteur. Le code opératoire OPi correspondant à cette opération ainsi que son opérande (V1) sont stockés à l'adresse suivante dans la première page P0 de la mémoire.

Selon les applications, l'unité de traitement peut provoquer ou non, avant écriture, la lecture de la valeur courante du compteur.

Au cours de la vie du compteur, des opérations de mise à jour (bloc 45, OPERATION) sont exécutées successivement et remplissent au fur et à mesure la première page de la mémoire (par exemple V2, OPi, ..., Vn, OPi).

Lorsque la page P0 est pleine, à l'écriture suivante, l'unité de contrôle commence par calculer (bloc 47, COMPUTE) la valeur courante du compteur à partir de la valeur initiale (00) et des n opérations de mise à jour stockées dans la page P0. Cette valeur VAL est alors stockée en tant que valeur initiale dans la page suivante P1 (bloc 43', INIT PAGE 1).

Par la suite, les opérations de mise à jour sont effectuées à partir de cette valeur VAL. Ainsi, il n'est pas nécessaire de recalculer tout le contenu du compteur depuis l'origine, mais simplement de la page courante.

De préférence, une fois qu'une page est pleine et que sa valeur finale a été transférée en guise de valeur initiale dans la page suivante, la page est effacée, c'est-à-dire que tous ses bits sont mis à 1. Un avantage est que cela participe à la protection du compteur en effaçant son historique.

Ainsi, une page peut être réutilisée par le compteur quand une autre page est pleine. Par exemple, dans un mode de réalisation simplifié, le compteur n'utilise que deux pages et alterne d'une page à l'autre.

Selon la nature du compteur, celui-ci exploite un ou plusieurs des quatre codes opératoires possibles. Par exemple, pour un compteur uniquement croissant, le code opératoire de soustraction n'est pas utilisé. A l'inverse, pour un compteur uniquement décroissant, la valeur initiale est FF et le code opératoire d'addition n'est pas utilisé.

Toutefois, selon un mode de réalisation préféré, le compteur est croissant et décroissant. Cela constitue un des avantages de la technique décrite qui est de permettre d'incrémenter et de décrémenter un même compteur en mémoire non volatile.

Le code optionnel d'absence d'opération correspond à annuler l'opération précédente. Par exemple, si une opération de rang i a incrémenté le compteur de 3 et que l'opération suivante souhaite le décrémenter de 3, on peut, au lieu de stocker les deux opérations successives d'incrément et de décrément, annuler l'opération d'incrément. Pour cela, la zone mémoire stockant l'opération d'incrément est annulée (mise à la valeur 0). La ligne est perdue mais on a utilisé qu'une ligne au lieu de deux. Une telle opération sert, par exemple, dans un compteur de protection contre des attaques d'un circuit intégré où le compteur est généralement incrémenté avant la fonction à surveiller, puis décrémenté de la même valeur à la fin de la fonction si aucune attaque n'a été détectée.

Le choix de la taille des pages conditionne le temps nécessaire à calculer la valeur du compteur (temps nécessaire à calculer les opérations depuis le début de la page).

Un avantage des modes de réalisation qui ont été décrits est qu'ils rendent possibles l'utilisation d'une mémoire flash pour stocker la valeur d'un compteur.

Un autre avantage est que la mise à jour du compteur est rapide en particulier par rapport au temps nécessaire à l'effacement d'une page dans une mémoire flash (ou EEPROM).

Divers modes de réalisation ont été décrits. Diverses variantes et modifications apparaîtront à l'homme de l'art. En particulier, la mise en oeuvre pratique des modes de réalisation qui ont été décrits est à la portée de l'homme du métier à partir des indications fonctionnelles données ci-dessus et en utilisant des circuits en eux-mêmes usuels. Notamment, l'organisation de l'adressage de la mémoire non volatile et la génération des signaux adaptés à sa commande et à cet adressage font appel à des techniques en elles-mêmes usuelles.

## Revendications

1. Procédé de stockage d'un compteur dans au moins deux pages de mémoire non volatile (3), comportant :
une étape (41) d'initialisation des au moins deux pages (P0, P1, PN) avec une valeur d'effacement initiale,
une étape (43, 43') de stockage dans une portion d'une des deux pages d'une valeur initiale du compteur ; puis
à chaque mise à jour de la valeur du compteur, une étape (45) de stockage, dans ladite une des deux pages, d'un code opératoire (OPi) et d'un opérande (V1) associé à ce code opératoire, choisi parmi un ensemble de codes opératoires,
la valeur courante du compteur étant donnée par application d'opérations de mise à jour successives à la valeur initiale du compteur stocké dans ladite une des deux pages, ces opérations étant désignées par les codes opératoires et les opérandes associés stockés dans ladite une des deux pages.

2. Procédé selon la revendication 1, dans lequel quand une page (P0) est pleine, sa valeur finale est calculée, puis stockée comme valeur initiale (VAL) dans la page suivante (P1) des au moins deux pages.

3. Procédé selon la revendication 1 ou 2, comportant une étape initiale (41) dans laquelle toutes les pages mémoire destinées au compteur sont initialisées dans un premier état.

4. Procédé selon l'une quelconque des revendications 1 à 3, dans lequel les codes opératoires comportent au moins un code parmi l'addition et la soustraction.

5. Procédé selon l'une quelconque des revendications 1 à 4, dans lequel les codes opératoires comportent un code d'effacement d'une page entière de la mémoire.

6. Procédé selon l'une quelconque des revendications 1 à 5, dans lequel les codes opératoires comportent un code d'effacement de l'opération précédente.

7. Procédé selon l'une quelconque des revendications 1 à 6, dans lequel une page comporte 32, 64, 128, 256, 512, 1024 ou 2048 octets.

8. Circuit électronique comportant :
une mémoire flash ; et
un circuit de contrôle configuré pour mettre en oeuvre le procédé selon l'une quelconque des revendications 1 à 7.

## Patentansprüche

1. Verfahren zur Speicherung eines Zählers in mindestens zwei Seiten eines nicht flüchtigen Speichers (3), umfassend:
einen Schritt (41) der Initialisierung der mindestens zwei Seiten (P0, P1, PN) mit einem Ausgangslöschwert,
einen Schritt (43, 43') der Speicherung eines Ausgangswerts des Zählers in einem Abschnitt einer der zwei Seiten; dann
bei jeder Aktualisierung des Werts des Zählers einen Schritt (45) der Speicherung in der einen der zwei Seiten, eines Operationscodes (OPi) und eines diesem Operationscode zugeordneten Operanden (V1), ausgewählt unter einer Gesamtheit von Operationscodes,
wobei der laufende Wert des Zählers durch Anwendung von aufeinanderfolgenden Aktualisierungsoperationen am Ausgangswert des in der einen der zwei Seiten gespeicherten Zählers gegeben ist, wobei diese Operationen durch die Operationscodes und die zugehörigen Operanden, die in der einen der zwei Seiten gespeichert sind, bezeichnet sind.

2. Verfahren nach Anspruch 1, bei dem, wenn eine Seite (P0) voll ist, ihr Endwert berechnet wird, dann als Ausgangswert (VAL) in der folgenden Seite (P1) der mindestens zwei Seiten gespeichert wird.

3. Verfahren nach Anspruch 1 oder 2, umfassend einen Anfangsschritt (41), bei dem alle für den Zähler bestimmten Speicherseiten in einem ersten Zustand initialisiert werden.

4. Verfahren nach einem der Ansprüche 1 bis 3, bei dem die Operationscodes mindestens einen Code unter Addition und Subtraktion umfassen.

5. Verfahren nach einem der Ansprüche 1 bis 4, bei dem die Operationscodes einen Löschcode einer ganzen Seite des Speichers umfassen.

6. Verfahren nach einem der Ansprüche 1 bis 5, bei dem die Operationscodes einen Löschcode der vorhergehenden Operation umfassen.

7. Verfahren nach einem der Ansprüche 1 bis 6, bei dem eine Seite 32, 64, 128, 256, 512, 1024 oder 2048 Oktett umfasst.

8. Elektronische Schaltung, umfassend:
einen Flash-Speicher; und
eine Kontrollschaltung, die dazu vorgesehen ist, das Verfahren nach einem der Ansprüche 1 bis 7 einzusetzen.

## Claims

1. Method for storing a counter in at least two pages of nonvolatile memory (3), comprising:
a step (41) of initializing the at least two pages (P0, P1, PN) with an initial erasure value,
a step (43, 43') of storing in a portion of one of the two pages an initial value of the counter; then
at each updating of the value of the counter, a step (45) of storing, in the said one of the two pages, an operation code (OPi) and an operand (V1) associated with this operation code, chosen from among a set of operation codes,
the current value of the counter being given by applying successive updating operations to the initial value of the counter stored in the said one of the two pages, these operations being designated by the operation codes and the associated operands stored in the said one of the two pages.

2. Method according to Claim 1, in which when a page (P0) is full, its final value is calculated, then stored as initial value (VAL) in the following page (P1) of the at least two pages.

3. Method according to Claim 1 or 2, comprising an initial step (41) in which all the memory pages intended for the counter are initialized in a first state.

4. Method according to any one of Claims 1 to 3, in which the operation codes comprise at least one code from among addition and subtraction.

5. Method according to any one of Claims 1 to 4, in which the operation codes comprise an erasure code for erasing an entire page of the memory.

6. Method according to any one of Claims 1 to 5, in which the operation codes comprise an erasure code for erasing the previous operation.

7. Method according to any one of Claims 1 to 6, in which a page comprises 32, 64, 128, 256, 512, 1024 or 2048 bytes.

8. Electronic circuit comprising:
a flash memory; and
a control circuit configured to implement the method according to any one of Claims 1 to 7.
